Europäisches Patentamt

European Patent Office

Office européen des brevets

(19)

(11) Publication number: **0 059 547**
**B1**

# EUROPEAN PATENT SPECIFICATION

(45) Date of publication of patent specification: **02.10.85**

(21) Application number: **82300746.3**

(22) Date of filing: **15.02.82**

(51) Int. Cl.⁴: **H 01 L 31/06,** H 01 L 27/14, H 01 L 31/18

(54) Clock controlled anti-blooming for virtual phase CCD's.

(30) Priority: **02.03.81 US 239793**

(43) Date of publication of application:
**08.09.82 Bulletin 82/36**

(45) Publication of the grant of the patent:
**02.10.85 Bulletin 85/40**

(84) Designated Contracting States:
**DE FR GB NL**

(56) References cited:
DE-A-2 606 108
US-A-3 866 067
US-A-3 896 474
US-A-4 024 563
US-A-4 028 716
US-A-4 173 064
US-A-4 229 752

RCA REVIEW, March 1974, vol. 35, Nr. 1, New York W.F. KOSONOCKY "Control of blooming in charge-coupled imagers" pages 3-24

(73) Proprietor: **TEXAS INSTRUMENTS INCORPORATED**
**13500 North Central Expressway**
**Dallas Texas 75265 (US)**

(72) Inventor: **Hosack, Harold H.**
**6911 Vista Willow Drive**
**Dallas Texas (US)**
Inventor: **Hynecek, Jaroslav**
**608 Tiffany Trail**
**Richardson Texas (US)**

(74) Representative: **Abbott, David John et al**
**Abel & Imray Northumberland House 303-306**
**High Holborn**
**London, WC1V 7LH (GB)**

(56) References cited:
THE BELL SYSTEM TECHNICAL JOURNAL, October 1972, New York C.H. SEQUIN "Blooming suppression in change coupled area imaging devices" pages 1923-1926

Courier Press, Leamington Spa, England.

## Description

The present invention relates to optical imagers, and particularly to a virtual phase CCD imager having an anti-blooming structure incorporated.

A charge-coupled device imaging array (hereinafter referred to as a CCD imager) may be thought of as a two-dimensional array of light sensing elements. Each element is essentially a suitably doped semiconductor substrate with an insulating layer over which are placed electrodes which, when properly biased, create potential storage wells in the substrate.

The array usually consists of elements organized into columns called channels, separated laterally from each other by heavily doped areas called channel stops.

When a scene is imaged onto the array, charge generated by the light incident upon an element is stored in corresponding potential wells. The light information is thereby converted into an electrical signal. The electrodes of the elements in a channel are sequentially clocked to move the individual charge packets down the channel to an output region where the amount of charge in each packet is detected.

The present invention addresses a problem that is common to all CCD imager structures, and thus pertains to all of them. This problem results when the imaging array is illuminated by a scene in which some regions are much brighter than others. The portions of the array receiving the more intense illumination will become overloaded, or, more charge is generated at a location than can be stored at that location. This excess charge tends to spread to the adjacent elements in the channel, as well as other channels. This spreading of charge is referred to as "blooming". "Blooming" is defined as the overflow of charge from an intensely illuminated element into the storage well of the adjacent elements in the same channel, or adjacent channels. This causes the image information around the intensely illuminated area to be lost.

The basic idea behind blooming control is to provide an overflow drain for excess charge in each element. Overflow drains can be placed between channels replacing the channel stops and be interconnected at the end of the imager opposite to the readout area. A potential barrier can then be created between each channel and drain, so that only excess charge in the channel will spill over into the drain. In U.S. Patent No. 4,173,064 is disclosed a method for creating this barrier by the use of electrodes, and creation of the drain by using the electrodes as a mask for implant of the impurities to form the drain region. This type of anti-blooming structure is not easily adaptable to the virtual phase CCD construction, since it requires an additional gate level which in turn lowers fabrication yield of the CCD devices. U.S. Patent No. 4,229,752 refers to the provision of blooming control structures between channels of a virtual phase charge transfer device according to the prior art portion of claim 1.

According to the present invention there is provided a charge-transfer device comprising: a semiconductor substrate of one conductivity type having formed therein a buried channel of opposite conductivity type to the substrate for charge transfer, bounded on one side by a channel stop region, and on the other side by a built-in anti-blooming structure, having an anti-blooming barrier and an overflow drain to dispose of excess charge generated in said channel; an insulating layer over said substrate; a conductive layer for receiving charge transfer clock pulses; and alternate clocked phase regions and virtual phase regions in said channel, the clocked phase region including a storage area and transfer area in that part of the channel underneath the clocked phase electrode, and the virtual phase region comprising a storage area and transfer area in that part of the channel underneath the virtual phase electrode; characterised in that the potential in the anti-blooming barrier is greater at selected portions along the length of the anti-blooming barrier than at other selected portions along the length of the same anti-blooming barrier.

The primary feature of the invention is the built-in barrier anti-blooming structure. This aspect of the invention provides for the potential level of the anti-blooming barrier to rise and fall with the clocking of the clocked phase electrode, and be at fixed level under the virtual phase electrode, instead of being set by an extra electrode which must be biased at a potential different from the clocked electrode. The absence of bias electrodes is a key to preserving the high yield potential offered by virtual phase device construction.

Another aspect of the invention is the alternation of drain and channel stop areas. This particular layout is required as a contact to the substrate via channel stop region, and is necessary to provide bias to each virtual phase electrode.

Brief Description of the Drawings

Figure 1 is a top view of a CCD cell of the invention with an anti-blooming structure incorporated.

Figure 2 is a cross-section of the cell channel showing the static potential profile.

Figure 3 shows the potential barriers along the channel in relationship to the clocked and virtual phase electrode when clocked phase is held at its most negative potential.

Figure 4 shows the anti-blooming concept.

Detailed Description of the Drawings

In the embodiment of the invention to be described, each virtual phase CCD imager cell includes a channel region bounded in a semiconductor substrate by channel stop regions, the structure of the cell being appropriate for light penetration into the channel region. The penetration of light into the channel region semiconductor material produces a charge which is stored in the potential well of the cell. The charge is transferred from cell to cell along the channel as the clocked phase electrode of each cell is pulsed. Each charge is converted to an output signal by a detecting circuitry at the channel output area. This particular type of imager structure is disclosed in U.S. Patent No. 4,229,752, but will not be further described except as it relates to structure of the present invention.

A preferred embodiment of the invention is fabricated on a substrate of semiconductor material, for example, silicon, and an N-channel imager (P-type substrate) is used. However, the concept of the invention is applicable also to the fabrication of P-channel (N-substrate) imager structures, as well as structures using other semiconductor materials, for example, germanium or gallium arsenide.

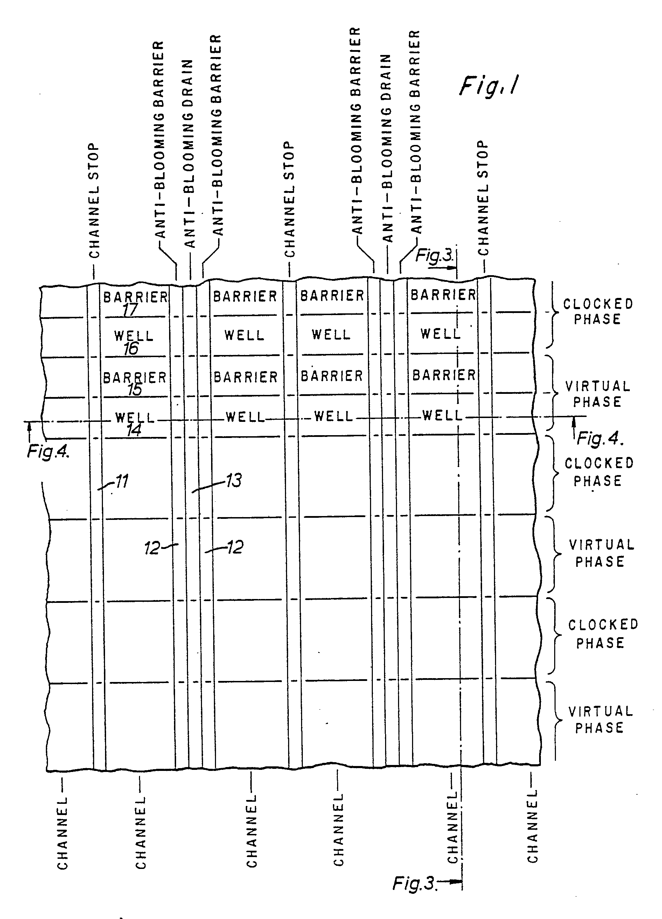

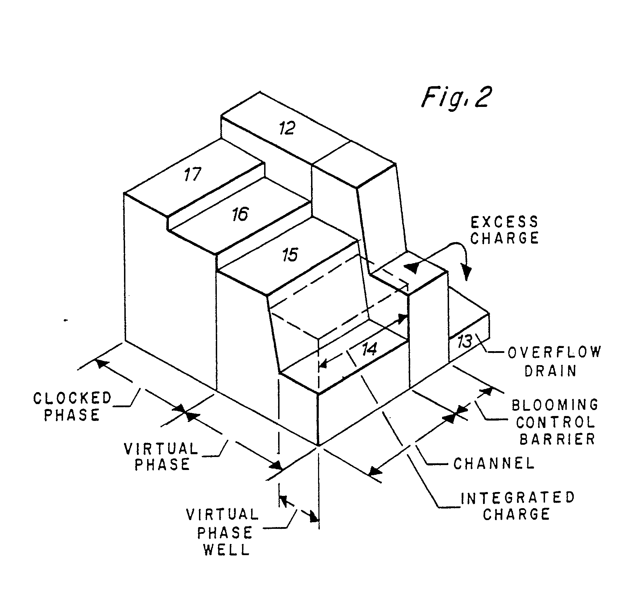

Referring to Figure 1, there is indicated in this top view of a virtual phase CCD imager cell several channel regions lying between the channel stops (11). Each channel region is bounded by the anti-blooming drain 13 and associated anti-blooming barrier 12 on one side and a regular P+ channel stop 11 on the other side. The channel region itself is divided into four areas within each cell, which constitute the clocked phase barrier area 17, clocked phase well area 16, virtual phase barrier area 15, and virtual phase well area 14.

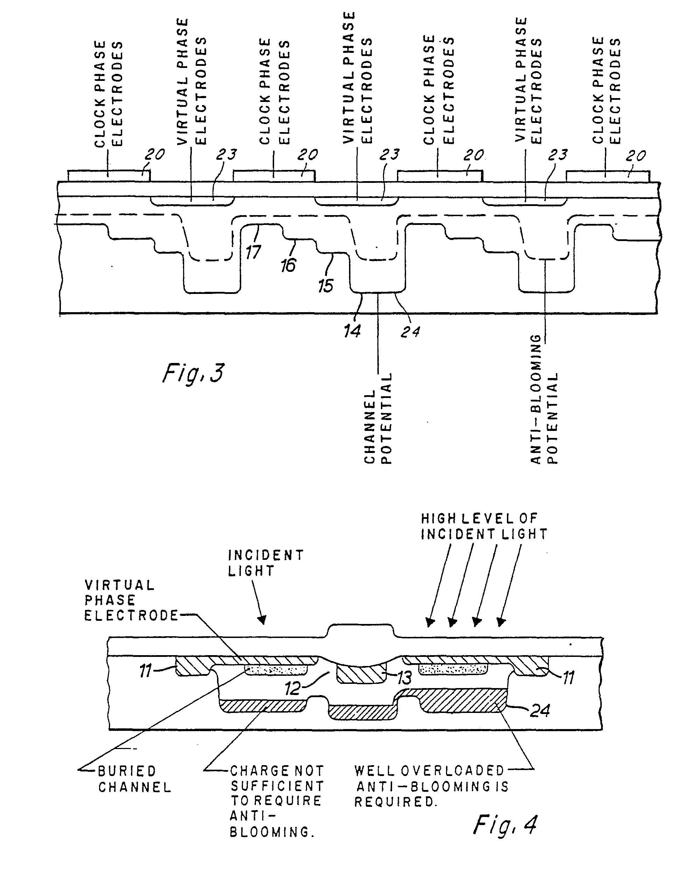

Figure 2 is an illustration of the potential profiles along the channel, and the relationship of the anti-blooming barrier to it. In this diagram, the "clocked phase" is held at a low potential, and the excess charge is removed from the virtual phase area. It is obvious to those skilled in the art that the overflow charge can also be drained from the clocked phase. Figure 3 is a cross-sectional view along the channel of the potential profiles which illustrates the operation of the anti-blooming structure. Figure 4 is a cross-sectional view across the channel. As shown, when the level of incident light focused on a cell does not create an amount of charge sufficient to overcome the anti-blooming barrier, the charge remains in the well, and is subsequently transferred down the channel to an output area. When the incident light level creates an amount of charge sufficient to overcome the anti-blooming, the excess charge spills over into the anti-blooming drain and drawn away by the drain bias.

In one method of fabrication of the anti-blooming structure a first insulating layer of silicon oxide is grown on a substrate, followed by a second layer of insulator, such as silicon nitride on the first insulating layer. A patterned layer of silicon oxide is then formed on the second insulating layer. The channel stops are formed by implantation through windows in the patterned layer into the substrate. The silicon nitride is then removed through other windows in the patterned layer and the drain implant made. The patterned layer is then removed, and the silicon wafer is oxidized. This causes the area immediately over the anti-blooming drain implant to grow thick oxide. Since the areas underneath the silicon nitride are not affected by the oxidation, no other portions of the surface are oxidized. The anti-blooming structure is now in place and further fabrication of standard virtual phase CCD's may be continued on the device.

The virtual phase CCD imager with anti-blooming structure incorporated provides the imager with overload protection of up to 10000×, which is sufficient for most applications.

In order to achieve the potential profile desired for operation with the anti-blooming drain, the implant of dopants in the correct dosage and at the proper energy level is an important part of the process. In a preferred embodiment, the channel stop area implant is Boron[11], at a dosage of $8.0 \times 10^{13}$ ions/cm$^2$, implant energy level of 60 KeV. The anti-blooming drain is a phosphorus implant of $1.0 \times 10^{15}$ ions/cm$^2$ at an implant energy level of 40 KeV. The first buried channel level implant is a phosphorus implant at a dosage of $1.5 \times 10^{12}$ ions/cm$^2$ and implant energy level of 340 KeV. The next (second) buried channel level is an optional step, a phosphorus implant at a dosage of $0.5 \times 10^{12}$ ions/cm$^2$, with an implant energy of 340 KeV.

While a particular embodiment of this invention has been disclosed herein, it will be understood that various modifications may become apparent to those skilled in the art without departing from the scope of the invention which is defined by the appended claims. It is also understood that while the embodiment described pertains to virtual phase CCD imagers of the frame transfer type, this anti-blooming structure can also be incorporated in other virtual phase CCD architectures — for example, interline transfer. It is also understood by those skilled in the art that the structures disclosed in this application can be fabricated on semiconductor materials of the opposite conductivity type, as well as on non-silicon semiconductors.

**Claims**

1. A charge-transfer device comprising:
a semiconductor substrate of one conductivity type having formed therein
a buried channel of opposite conductivity type to the substrate for charge transfer, bounded on one side by a channel stop region, and on the other side by a built-in anti-blooming structure, having an anti-blooming barrier and an overflow drain to dispose of excess charge generated in said channel;
an insulating layer over said substrate;
a conductive layer for receiving charge transfer clock pulses; and
alternate clocked phase regions and virtual phase regions in said channel, the clocked phase region including a storage area and transfer area in that part of the channel underneath the clocked phase electrode, and the virtual phase region comprising a storage area and transfer area in that part of the channel underneath the virtual phase electrode;

characterised in that the potential in the anti-blooming barrier is greater at selected portions along the length of the anti-blooming barrier than at other selected portions along the length of the same anti-blooming barrier.

2. The device according to claim 1 characterised in that the anti-blooming barrier potential is lowest at that portion of the anti-blooming barrier which is adjacent to the virtual phase storage area.

3. The device according to claim 2 characterised in that the anti-blooming barrier potential adjacent to the virtual phase well storage area is lower than the channel potential of the virtual phase transfer area in the channel.

4. The device according to claim 1 characterised in that the anti-blooming barrier potential is fixed over time at that portion adjacent to the virtual phase storage area.

5. The device according to claim 4 characterised in that the potential level of the anti-blooming barrier is variable adjacent to the clocked phase channel region and is at a fixed level adjacent to the virtual phase channel region.

6. A charge transfer device according to any preceding claim for a virtual-phase CCD imager having a plurality of parallel charge transfer channels which form the signal channels in said imager, characterised in that each anti-blooming structure located between two channels comprises two anti-blooming barriers which are adjacent to and on either side of one overflow drain.

**Patentansprüche**

1. Ladungsübertragungsvorrichtung mit einem Halbleitersubstrat eines Leitungstyps, in dem ein vergrabener Kanal mit einem dem Leitungstyp des Substrats entgegengesetzten Leitungstyp zur Ladungsübertragung angebracht ist, der auf einer Seite durch einen Kanalbegrenzungsbereich und auf der anderen Seite durch eine eingebaute, eine Überstrahlung verhindernde Struktur begrenzt ist, die eine eine Überstrahlung verhindernde Barriere und einen Überlauf-Drainbereich zum Abführen einer überschüssigen, in dem Kanal erzeugten Ladung aufweist, einer Isolierschicht über dem Substrat, einer leitenden Schicht zum Empfangen von Ladungsübertragungs-Taktimpulsen und abwechselnd getakteten Phasenzonen und virtuellen Phasenzonen in den Kanal, wobei die getaktete Phasenzone einen Speicherbereich und einen Übertragungsbereich in dem unterhalb der getakteten Phasenelektrode liegenden Teil des Kanals enthält, während die virtuelle Phasenzone einen Speicherbereich und einen Übertragungsbereich in dem unter der virtuellen Phasenelektrode liegenden Teil des Kanals enthält, dadurch gekennzeichnet, daß das Potential in der das Überstrahlen verhindernden Barriere an ausgewählten Abschnitten längs dieser Barriere größer als an anderen ausgewählten Abschnitten längs der gleichen Barriere ist.

2. Vorrichtung nach Anspruch 1, dadurch gekennzeichnet, daß das Potential in der das Überstrahlen verhindernden Barriere an dem Abschnitt der Barriere am niedrigsten ist, der an den Speicherbereich der virtuellen Phasenzone angrenzt.

3. Vorrichtung nach Anspruch 2, dadurch gekennzeichnet, daß das Potential der aus Überstrahlen verhindernden Barriere angrenzend an den Speicherbereich der virtuellen Phasenzone niedriger als das Kanalpotential des Übertragungsbereichs der virtuellen Phasenzone in den Kanal ist.

4. Vorrichtung nach Anspruch 1, dadurch gekennzeichnet, daß das Potential der das Überstrahlen verhindernden Barriere an dem an den Speicherbereich der virtuellen Phasenzone angrenzenden Abschnitt zeitlich fest ist.

5. Vorrichtung nach Anspruch 4, dadurch gekennzeichnet, daß der Potentialpegel der das Überstrahlen verhindernden Barriere angrenzend an den Kanalbereich der getakteten Phasenzone variabel und angrenzend an den Kanalbereich der virtuellen Phasenzone fest ist.

6. Ladungsübertragungsvorrichtung nach einem der vorhergehenden Ansprüche für eine CCD-Abbildungseinrichtung mit virtueller Phase mit mehreren parallelen Ladungsübertragungskanälen, die die Signalkanäle der Abbildungseinrichtung bilden, dadurch gekennzeichnet, daß jede zwischen zwei Kanälen angeordnete, das Überstrahlen verhindernde Struktur zwei das Überstrahlen verhindernde Barrieren aufweist, die beiderseits jeweils an einen Überlauf-Drainbereich angrenzen.

**Revendications**

1. Dispositif à transfert de charge comprenant:
un substrat semi-conducteur d'un type de conductivité, dans lequel est formé
un canal enfoui du type de conductivité opposé à celle du substrat en vue du transfert de charge, limité d'un côté par une région de séparation de canaux, et de l'autre, par une structure anti-flou incorporée comportant une barrière anti-flou et un drain de débordement pour éliminer l'excès de charge engendré dans ledit canal;
une couche isolante placée sur ledit substrat;
une couche conductrice pour recevoir les impulsions de synchronisation de transfert de charge; et
des régions de phase synchronisée alternées avec des régions de phase virtuelle dans ledit canal, la région de phase synchronisée incluant une zone d'emmagasinage et une zone de transfert dans la partie du canal situé sous l'électrode de phase synchronisée, et la région de phase virtuelle comprenant une zone d'emmagasinage et une zone de transfert dans la partie du canal située sous l'électrode de phase virtuelle;
caractérisé en ce que le potentiel dans la barrière anti-flou est supérieur, dans des parties sélectionnées sur la longueur de ladite barrière anti-flou, au potentiel présent dans d'autres parties sélectionnées le long de cette même barrière anti-flou.

2. Dispositif selon la revendication 1, caractérisé en ce que le potentiel de la barrière anti-flou est au niveau le plus bas dans la partie de la barrière anti-flou qui est contiguë à la zone d'emmagasinage de phase virtuelle.

3. Dispositif selon la revendication 2, caractérisé en ce que le potentiel de la barrière anti-flou contiguë à la zone d'emmagasinage de la cuvette de phase virtuelle, est inférieur au potentiel de canal de la zone de transfert de phase virtuelle du canal.

4. Dispositif selon la revendication 1, caractérisé en ce que le potentiel de la barrière anti-flou, dans la partie contiguë à la zone d'emmagasinage de phase virtuelle, est fixe dans le temps.

5. Dispositif selon la revendication 4, caractérisé en ce que le niveau de potentiel de la barrière anti-flou est variable dans la partie contiguë à la région de phase synchronisée du canal, et est à un niveau fixe dans la partie contiguë à la région de phase virtuelle du canal.

6. Dispositif à transfert de charge selon l'une quelconque des revendications précédentes, destiné à un générateur d'images DCC à phase virtuelle, comprenant plusieurs canaux à transfert de charge parallèles qui forment les canaux de signal dans ledit générateur d'images, caractérisé en ce que chaque structure anti-flou située entre deux canaux comprend deux barrières anti-flou placées de part et d'autre d'un drain de débordement et contiguës à ce dernier.

0 059 547

Fig.1

Fig. 2

Fig. 3

CLOCK PHASE ELECTRODES / VIRTUAL PHASE ELECTRODES 20 23

CHANNEL POTENTIAL

ANTI—BLOOMING POTENTIAL

14 24 15 16 17

Fig. 4

VIRTUAL PHASE ELECTRODE

INCIDENT LIGHT

HIGH LEVEL OF INCIDENT LIGHT

11 12 13 11 24

BURIED CHANNEL

CHARGE NOT SUFFICIENT TO REQUIRE ANTI—BLOOMING.

WELL OVERLOADED ANTI—BLOOMING IS REQUIRED.